# EUROPÄISCHE PATENTSCHRIFT

(11) **EP 0 642 698 B1**
(45) Veröffentlichungstag und Bekanntmachung des Hinweises auf die Patenterteilung: **18.09.1996**
(21) Anmeldenummer: 93909798.6
(22) Anmeldetag: 24.05.1993
(51) Int. Cl.: H01L 23/473

(54) **FLUIDGEKÜHLTE LEISTUNGSTRANSISTORANORDNUNG**
FLUID-COOLED POWER TRANSISTOR ARRANGEMENT
CONFIGURATION DE TRANSISTORS DE PUISSANCE REFROIDIE PAR FLUIDE

(30) Priorität: 25.05.1992 DE 4217289
(43) Veröffentlichungstag der Anmeldung: 15.03.1995
(73) Patentinhaber: FICHTEL & SACHS AG, D-97424 Schweinfurt (DE)
(72) Erfinder: LUTZ, Dieter, D-97422 Schweinfurt (DE)
(74) Vertreter: Meissner, Peter E., Dipl.-Ing.
(86) Internationale Anmeldenummer: DE9300465
(87) Internationale Veröffentlichungsnummer: WO9324955

(56) Entgegenhaltungen:
- EP-A- 0 007 015
- EP-A- 0 116 802
- EP-A- 0 217 676
- EP-A- 0 410 631
- GB-A- 1 488 386
- IBM TECHNICAL DISCLOSURE BULLETIN. Bd. 20, Nr. 11A, April 1978, NEW YORK US Seiten 4346 - 4348 P.W. HARDIN 'Integral Edge Connector'

## Beschreibung

Die Erfindung betrifft allgemein das Gebiet der Fluidkühlung von Halbleiterelementen, insbesondere eine fluidgekühlte Leistungstransistoranordnung.

Zur Steuerung elektrischer Geräte und Maschinen werden in großem Umfang Halbleiterventile eingesetzt. Maßgebend für die Art des einzusetzender, Ventils ist einerseits die Größe der zu steuernden Leistung und andererseits die maximale Betriebsfrequenz. Thyristoren und Triacs werden bei Netzfreouenz, d.h. in der Größenordnung von 50 Hz, eingesetzt und erlauben Leistungssteuerungen bis in der Größenordnung von 10 MegaWatt. Für eine Vielzahl Anwendungsfälle, insbesondere bei der Steuerung elektrischer Maschinen, werden jedoch höhere Schaltfrequenzen bis nahe an den Mega-Hertz-Bereich gefordert. Für Anwendungsfälle dieser Art werden Leistungstransistoren eingesetzt. Im Frequenzbereich um 10 kHz bei Leistungen in der Größenordnung zwischen 10 und 100 kW können BIMOS-Leistungstransistoren und IGBT-Leistungstransistoren (Insulated Gate Bipolar Transistor) eingesetzt werden. Zu höheren Frequenzen hin, jedoch bei niedrigeren Leistungen, werden üblicherweise MOSFET-Leistungstransistoren eingesetzt.

Leistungshalbleiterelemente müssen gekühlt werden. Im aktiven Bereich des Halbleiterelements dürfen die Temperaturen nicht über verhältnismäßig niedrige Temperaturwerte hinaus ansteigen. Die Verlustwärme muß nicht nur durch das Halbleitersubstrat hindurch abgeführt werden, sondern auch durch Elektrodenplattierungen und mehrschichtige Trägerplatten, auf die das Halbleitersubstrat aufgebracht ist. Bei Leistungstransistoren der vorstehend erläuterten Art ist das Halbleitersubstrat zumindest auf einer Seite flächig mit einer den gesamten aktiven Bereich des Substrats überlappenden, je nach Typ den Kollektor oder die Drain-Elektrode bildenden Basis-Metallplattierung versehen. Die übrigen Elektroden des Transistors, also Basis und Emitter oder Gate- bzw. Source-Elektrode, sind auf der gegenüberliegenden Flachseite des Halbleitersubstrats zugänglich. Bei herkömmlichen Leistungstransistoren schließt an die flächige Basis-Metallplattierung eine fluidgekühlte Kühlkörperanordnung an, die die Verlustwärme des aktiven Bereichs des Transistors durch das Halbleitersubstrat und die Basis-Metallplattierung hindurch abführt. Da die Temperatur im aktiven Bereich gleichmäßig innerhalb der vorgegebenen Grenzwerte gehalten werden muß, kommt es darauf an, daß die Kühlkörperanordnung flächig mit gleichmäßigen Wärmeübergangseigenschaften an das Halbleitersubstrat des Halbleiterelements anschließt. Ein direkter Anschluß des Kühlkörpers an das Halbleitersubstrat ist angesichts der hohen Spannungen (1000 V und mehr) und hohen Ströme (beispielsweise 100 Ampere) in der Regel nicht möglich, so daß das Halbleitersubstrat auf einem Isolierträger aufgebracht werden muß, über den bei bisherigen Leistungstransistoranordnungen die Verlustwärme aus dem Halbleiterelement in die Kühlanordnung abgeleitet werden muß. So ist es üblich, das Halbleiterelement auf einer beidseitig kupferplattierten Keramikplatte aufzubringen und die Keramikplatte mit der dem Halbleiterelement fernen Seite auf eine Trägerplatte, zum Beispiel aus Stahl, aufzulöten. Die Stahlplatte wird ihrerseits mit einer Zwischenschicht einer Wärmeleitpaste auf das beispielsweise wassergekühlte Kühlelement aufgesetzt. Geeignete Kühlkörperanordnungen sind beispielsweise aus EP-A-447 835 bekannt. Es hat sich jedoch gezeigt, daß die Schaltleistungskapazität von Leistungstransistoren vielfach nicht vollständig ausgenutzt werden kann, oder aber es zu Ausfällen von Leistungstransistoren kommt, wenn in der die Keramikplatte mit der stahlplatte verbindenden Lötschicht oder in der Wärmeleitpastenbeschichtung Inhomogenitäten verbleiben, die zu einer lokalen überhitzung des Halbleiterelements und damit zur Zerstörung des Transistors führen können.

Zur Verbesserung der Kühlwirkung von Leistungstransistoren ist es bekannt, die auf der substratfernen Seite angeschlossenen Zuleitungsbänder mit Kühlkörpern zu versehen, die die Kühlung des aktiven Bereichs des Halbleiterelements verstärken (EP-A-252 429 und EP-A-449 435). Gleichfalls ist es bekannt (EP-A-260 370), auf der von der aktiven Fläche fernen Flachseite des Halbleiterelements einen mit Kühlrippen versehenen Kühlkörper stoffschlüssig anzubringen und die Kühlrippen einer Kühlluftströmung auszusetzen.

Schließlich ist es aus der DE-A-41 01 205 bekannt, das plattenförmige Halbleiterelement einer Leistungsdiode bzw. eines Leistungsthyristors in einem Kühlfluidkanal anzuordnen und beidseitig durch nachgiebige Kontaktbürsten zu kontaktieren. Die Kontaktbürsten bestehen jeweils aus einer Vielzahl einzelner untereinander paralleler Drahtstücke, die durch das am Halbleiterelement entlang strömende Kühlfluid gekühlt werden. Die Kontaktbürsten erlauben jedoch keine flächige Wärmeabfuhr, wie sie für die Kühlung des Halbleiterelements eines Leistungstransistors erforderlich wäre. Als Kühlfluid wird in DE-A-41 01 205 Wasser, Luft, öl oder ein kohlenwasserstoffhaltiges Kühlmittel vorgeschlagen.

Es ist Aufgabe der Erfindung, eine fluidgekühlte Leistungstransistoranordnung zu schaffen, bei der zuverlässiger als bisher für eine gleichmäßige Kühlung des Halbleiterelements der Leistungstransistoranordnung gesorgt ist.

Die Erfindung geht von einer fluidgekühlten Leistungstransistoranordnung inbesondere für elektrische Ventilanordnungen aus, welche umfaßt:
ein plattenförmiges Transistor-Halbleiterelement (1) , das auf einer ersten seiner Flachseiten mit einem über das Halbleiterelement (1) vorstehenden, elektrisch isolierenden Isolierträger (9; 9a; 7b, 9b; 9c) verbunden ist, der mit mindestens einer seiner Flachseiten innerhalb einer Kühlfluid-Zwangsströmung (15) eines Fluidkanals (13) angeordnet ist, der in Wärmeübertragungskontakt mit zumindest einer der Flachseiten des Halbleiterelementes (1) steht und mit Mitteln zur Erzeugung der Kühlfluid-Zwangsströmung (15) verbunden ist.

Ausgehend von einer solchen Leistungstransistoranordnung wird die vorstehende Aufgabe gemäß dem Patentanspruch 1 dadurch gelöst,
daß das Transistor-Halbleiterelement (1) auf einer seiner Flachseiten eine dieselbe abdeckende, in ihrer Flächenausdehnung die Fläche des Halbleiterlementes (1) überragende Metallelektrode (7) trägt, die geschlossenflächig, stoffschlüssig mit dem Halbleiterelement (1) verbunden ist und auf seiner anderen Flachseite mehrere im Abstand voneinander stoffschlüssig angebrachte Anschlüsse (5) aufweist,
daß das Halbleiterlement (1) über seine mit dem Isolierträger (9; 9a; 7b, 9b, 9C) gemeinsame Kontaktfläche der Kühlwirkung der Kühlfluid-Zwangsströmung (15) ausgesetzt ist, und
daß auf dem Isolierträger (9; 9a; 7b, 9b; 9c) eine Steuer- und Schutzbeschaltung (3) für das Halbleiterelement (1) angeordnet ist.

Vorteilhafte Weiterbildungen der Erfindung sind in den Unteransprüchen 2 - 28 angegeben.

Der Erfindung liegt die Idee zugrunde, die bei herkömmlichen Leistungstransistoren für die Befestigung am Kühlkörper vorgesehenen Trägerplatten bis auf den für den Betrieb erforderlichen Isolierträger wegzulassen und statt dessen mindestens eine Flachseite, vorzugsweise den Isolierträger und gegebenenfalls das Halbleiterelement im Bereich seiner Metallelektrode direkt und möglichst über seine gesamte Flachseitenfläche dem Kühlfluid auszusetzen. Zusätzlich kann das gegebenenfalls mit einer dünnen Schutzbeschichtung versehene Halbleiterelement auch an der dem Isolierträger abgewandten Seite dem Kühlfluid ausgesetzt werden. Die Metallelektrode ist stoffschlüssig und vollflächig mit dem Isolierträger verbunden. Sie sollte in ihrer Flächenausdehnung die Fläche des Halbleiterelements möglichst deutlich überragen und vorzugsweise um mindestens 50 % größer sein als die Flachseite des Halbleiterelements. Der Metallelektrode kommt dabei nämlich neben ihrer elektrischen eine weitere wichtige Funktion zu, da sie nicht nur die entstehende Wärme schnell aufnehmen und weiterleiten muß, sondern darüberhinaus auch in der Fläche verteilen muß. Auf diese Weise läßt sich eine gleichmäßige Kühlung des Halbleiterelements erreichen, da stoffschlüssige Verbindungen zwischen aufeinanderfolgenden Materialschichten, beispielsweise von Trägerolatten oder dergleichen, auf ein Minimum beschränkt sind. Bei dem Kühlfluid kann es sich um ein Gas, vorzugsweise ein unter Druck stehendes Gas, wie zum Beispiel Stickstoff, oder eine Flüssigkeit, wie zum Beispiel Wasser oder öl, speziell öl auf Mineralbasis oder Paraffinbasis, oder ein synthetisches öl handeln; es kann sich aber auch um ein Zwei-Phasen-Fluid, vorzugsweise ein Kältemittel oder CO₂ handeln.

Die Anordnung der Steuer- und Schutzbeschaltung für das Halbleiterelement auf demselben Isolierträger bringt eine Reihe von Vorteilen mit sich. Es erfolgt nicht nur eine thermische Kopplung der beteiligten Bauelemente, sondern es entfällt auch eine separate Kühlung der Steuer- und Schutzbeschaltung. Die erforderlichen Verbindungsleitungen werden minimiert, was der Störungssicherheit zu gute kommt. Es führt nur eine geringe Zahl von Anschlußleitungen nach außen.

Die Erfindung ist speziell für IGBT-Leistungstransistoren geeignet, jedoch auch für MOSFET-Leistungstransistoren, die bei hohen Betriebsfrequenzen Leistungen im Bereich von 100 kW und mehr und insbesondere Ströme von 5 - 100 A bei Spannungen von 100 - 1000 V schalten können.

Der Isolierträger wird wie bisher zur Befestigung des Halbleiterelements ausgenutzt. Bei dem Isolierträger kann es sich um eine Trägerplatte aus Isoliermaterial, insbesondere Keramik handeln, an der das Halbleiterelement mit seiner Metallelektrode geschlossenflächig, stoffschlüssig angebracht ist. Alternativ kann der Isolierträger aber auch als zumindest auf einer Flachseite mit einer Isolierschicht versehene Metallplatte ausgebildet sein, also beispielsweise als mit einer isolierenden Oxidschicht versehene Metallplatte ausgebildet sein. Die letztgenannte Ausgestaltung ist insbesondere deswegen von Vorteil, weil die Metallplatte zugleich integral die Metallelektrode bilden kann.

Das Halbleiterelement kann vollständig in dem Kühlfluidkanal angeordnet sein, so daß das Kühlfluid sowohl auf der Seite des zweckmäßigerweise als Platte ausgebildeten Isolierträgers als auch auf der dem Isolierträger abgewandten Seite des Halbleiterelements kühlend entlangströmt. In einer bevorzugten Ausgestaltung mit einem plattenförmigen Isolierträger ist jedoch vorgesehen, daß der Isolierträger eine Wand des Kühlfluidkanals bildet. Diese Ausgestaltung ist insbesondere dann zweckmäßig, wenn der Isolierträger mehrere Halbleiterelemente nebeneinander, insbesondere in Richtung der Kühlfluid-Zwangsströmung hintereinander angeordnet gemeinsam trägt, da sich auf diese Weise mehrere elektrische Ventile, beispielsweise in Form von ein oder mehreren Halb- oder Vollbrücken modulartig aufbauen lassen. Zu besonders einfachen Lösungen gelangt man, wenn zumindest zwei sich gegenüberliegende Wände des Kühlfluidkanals durch plattenförmige, jeweils wenigstens ein Halbleiterelement tragende Isolierträger gebildet sind. Um eine gleichmäßige Kühlung und Wärmedehnung zu erreichen, tragen die beiden sich gegenüberliegenden Isolierträger bevorzugt eine gleiche Anzahl Halbleiterelemente. In der einfachsten Ausgestaltung genügt es, wenn die sich gegenüberliegenden Isolierträger durch Dichtleisten zu einem in Umfangsrichtung geschlossenen Kühlfluidkanal verbunden sind.

Bei den vorstehend erläuterten Ausgestaltungen, bei welchen die Isolierträger Wände des Kühlfluidkanals bilden, können die Halbleiterelemente auf der Innenseite des Kühlfluidkanals oder auch auf der Außenseite angeordnet sein, wobei letztere Gestaltung den Vorteil hat, daß sie leichter angeschlossen werden kann.

Bei herkömmlichen Leistungstransistoren überlappt der üblicherweise plattenförmige Isolierträger geschlossenflächig das Halbleiterelement. In einer bevorzugten Ausgestaltung der Erfindung kann im Gegensatz zu Isolierträgern herkömmlicher Leistungstransistoren der Isolierträger auch so ausgebildet sein, daß er nur partiell mit dem Halbleiterelement überlappt, vorzugsweise gerade so viel, daß das Halbleiterelement dauerhaft an dem Isolierträger befestigt werden kann. Dies hat den Vorteil, daß die mit der Metallelektrode versehene Flachseite des Halbleiterelements ohne Zwischenschaltung des Isolierträgers unmittelbar der Kühlfluidströmung ausgesetzt werden kann. Als Isolierträger werden dabei Wände des Kühlfluidkanals ausgenutzt. Der Isolierträger, bei dem es sich wiederum um eine Isoliermaterial-Platte handeln kann, ist zweckmäßig mit einer durchgehenden Aussparung versehen, an deren Rändern das Halbleiterelement befestigt und zumindest mit seiner ersten Flachseite durch die Aussparung hindurch der Kühlfluidströmung ausgesetzt ist. Insbesondere kann der Isolierträger darüber hinaus auch quer zur ersten Flachseite des Halbleiterelements verlaufende Seitenwände des Kühlfluidkanals aufweisen, beispielsweise in der Form, daß der Isolierträger zumindest im Bereich der Aussparung im wesentlichen U-förmigen Querschnitt hat, so daß an den Rändern der durch den U-förmigen Querschnitt gebildeten Schenkel das Halbleiterelement aufsitzt und insgesamt ein Kühlfluidkanal mit etwa rechteckigem Querschnitt gebildet wird.

Es versteht sich, daß auch in der Ausgestaltung, bei welcher der Isolierträger lediglich teilweise mit den Flachseiten des Halbleiterelements überlappt, mehrere der Halbleiterelemente an einem gemeinsamen Isolierträger zu einem Modul zusammengefaßt werden könnten. Dies kann beispielsweise dadurch geschehen, daß der Isolierträger als Profilkörper ausgebildet ist, der wenigstens ein oder mehrere in Strömungsrichtung des Kühlfluids hintereinander angeordnete Halbleiterelemente trägt, von denen jedes zumindest einen Leistungstransistor umfaßt. Der zur Bildung des Kühlfluidkanals ausgenutzte Isolierträger kann neben den quer zum Halbleiterelement verlaufenden Seitenwänden des Kühlfluidkanals auch Teile der in der Ebene des Halbleiterelements verlaufenden Wände bilden.

Bei der vorstehend erläuterten Ausgestaltung können die Halbleiterelemente jeweils für sich und voneinander gesondert an dem Profilkörper befestigt sein. Nachdem die Halbleiterelemente jedoch entsprechend herkömmlichen Herstellungsverfahren in größerer Anzahl auf einem gemeinsamen Halbleitersubstrat hergestellt werden, ist in einer bevorzugten Ausgestaltung vorgesehen, daß jeweils mehrere einteilig miteinander verbundene Halbleiterelemente an dem Profilkörper befestigt werden. Dies erleichtert die Abdichtung des Kühlfluidkanals.

Eine besonders einfache Ausgestaltung, bei welcher mehrere Halbleiterelemente zu einem Modul zusammengefaßt werden können, sieht vor, daß zumindest zwei sich gegenüberliegende Wände des Kühlfluidkanals im wesentlichen vollständig durch jeweils wenigstens ein Halbleiterelement gebildet sind und die sich gegenüberliegenden Halbleiterelemente durch Dichtleisten zu einem in Umfangsrichtung geschlossenen Kühlfluidkanal verbunden sind. Die Dichtleisten können durch Wände gebildet sein, die gegebenenfalls in ihrer Höhe die Breite der Halbleiterelemente übertreffen; bei den Dichtleisten kann es sich aber auch um vergleichsweise flache Leisten handeln.

Bei der Kühlfluidströmung handelt es sich um eine Zwangsströmung, um einen hinreichenden Wärmetransport zu gewährleisten. Um eine Verschmutzung oder Kontaminierung des Halbleiterelements oder des Isolierträgers zu verhindern, umfaßt die Fluid-Kühlanordnung zweckmäßigerweise einen geschlossenen Kühlfluidkreislauf, in welchem das Kühlfluid nacheinander durch den Kühlfluidkanal und einen Kühler, d.h. einen die Wärme nach außen abgebenden Wärmetauscher, zirkuliert. Soweit als Kühlfluid ein Zwei-Phasen-Fluid benutzt wird, umfaßt der Kühlfluidkreislauf bevorzugt einen Verdampfer und einen Kondensator, wobei der Kühlfluidkanal den Verdampfer bildet. Eine solche nach Art einer Wärmepumpe arbeitende Anordnung erlaubt auch bei geringerer Fluidströmung eine hinreichende Kühlung.

Insbesondere bei Isolierträgern, die vollflächig mit dem Halbleiterelement verbunden sind, kann die Kühlleistung erhöht werden, wenn der Isolierträger auf seiner dem Halbleiterelement abgewandten, der Kühlfluidströmung ausgesetzten Seite mit einer seine Wärmetauschfläche vergrößernden Struktur, insbesondere Rippen oder Vorsprüngen, versehen ist. Soweit im Vorstehenden von plattenförmigen Isolierträgern die Rede ist, sollen derartige Strukturen jeweils mit eingeschlossen sein.

Die Verwendung von Rippen oder dergleichen zur Vergrößerung der Wärmetauschflächen bei Kühlanordnungen, wie zum Beispiel Kühlkörpern oder dergleichen, ist bekannt. Unter einem zweiten Aspekt betrifft die Erfindung Maßnahmen, durch die die Kühlleistung der Fluid-Kühlanordnung erhöht werden kann. Eine solche Fluid-kühlanordnung kann nicht nur bei einer Leistungstransistoranordnung der vorstehend erläuterten Art eingesetzt werden, sondern eignet sich allgemein zur Kühlung von Halbleiterelementen, gegebenenfalls auch solchen mit indirekter Kühlung über einen fluidgekühlten Kühlkörper. Gemäß dem zweiten Aspekt der Erfindung ist vorgesehen, daß zumindest ein Teil der Wandoberfläche des Kühlfluidkanals, der der Kühlfluidströmung ausgesetzt ist, bzw. bei einer Leistungstransistoranordnung gemäß der vorstehend erläuterten Art zumindest ein Teil der Oberfläche des Isolierträgers oder des Halbleiterelements mit einer die Dicke der Kühlfluid-Strömungsgrenzschicht mindernden Oberflächen-Mikrostruktur versehen ist. Die Erfindung geht hierbei von der Überlegung aus, daß der Kühleffekt der Kühlfluidströmung umso größer ist, je geringer die Dicke der Strömungsgrenzschicht ist, innerhalb der die Kühlfluidströmung auf Scherung beansprucht und gebremst wird. überraschenderweise hat sich gezeigt, daß Mikrostrukturen, die die Oberflächenreibung mindern, eine Verbesserung der Kühlwirkung einer Kühlfluidströmung bewirken, da sie die Grenzschichtdicke herabsetzen. Mikrostrukturen, die die Reibung von Flüssigkeiten an Oberflächen mindern, sind bekannt und wurden unter anderem an der Haut von Haifischen studiert (D. Bechert und M. Bartenwerfer "The Viscous Flow on Surfaces with Longitudinal Ribs" J. Fluidmec. 1989), Vol. 206, Seiten 105 bis 129, und D. Bechert, G. Hoppe "0n the Drag Reduction of the Shark Skin" AIAA Share Flow Control Conference, March 12-14, 1985, Boulder, Colorado).

Als besonders geeignet zur Kühlleistungsverbesserung haben sich Mikrostrukturen erwiesen, die als Rippenmuster mit in Strömungsrichtung der Kühlfluidströmung langgestreckten, im wesentlichen parallelen Mikrorippen ausgebildet sind, und zwar insbesondere dann, wenn die Mikrorippen zumindest angenähert zu einer Schneide sich verjüngende Rücken haben. Die Höhe der Rippen und ihr Querabstand liegt zweckmäßigerweise in der Größenordnung der Grenzschichtdicke oder ist kleiner als die Grenzschichtdicke. Bei dem Kühlfluid handelt es sich zweckmäßigerweise um ein Einstoffsystem.

Im folgenden werden Ausführungsbeispiele der Erfindung anhand einer Zeichnung näher erläutert. Hierbei zeigt:
- Figur 1: eine teilweise geschnittene, perspektivische Darstellung einer fluidgekühlten Leistungstransistoranordnung;
- Figur 2 bis 4: Schnittansichten von Varianten der Leistungstransistoranordnung nach Figur 1;
- Figur 5: eine perspektivische Darstellung eines fluidgekühlten Moduls mit mehreren Leistungstransistoren;
- Figur 6: eine Schnittansicht des Moduls, gesehen entlang einer Linie VI-VI in Figur 5;
- Figur 7: eine Schnittansicht einer Variante des Moduls aus Figur 5;
- Figur 8: eine Schnittansicht einer aus mehreren Modulen bestehenden Baueinheit;
- Figur 9: eine schematische Darstellung einer Flüssigkeitskühlanordnung für einen Leistungstransistor;
- Figur 10: eine schematische Darstellung einer Kältemittel-Kühlanordnung für einen Leistungstransistor;
- Figur 11: eine schematische Darstellung einer Kühlanordnung mit gasförmigem Kühlfluid für einen Leistungstransistor;
- Figur 12: eine perspektivische Darstellung einer Oberflächen-Mikrostruktur zur Verbesserung der Kühlleistung eines fluidgekühlten elektrischen Ventils;
- Figur 13: eine Variante der Oberflächen-Mikrostruktur;
- Figur 14: eine Schnittansicht durch die Oberflächen-Mikrostruktur, gesehen entlang der Linie XIV-XIV in Figur 13.

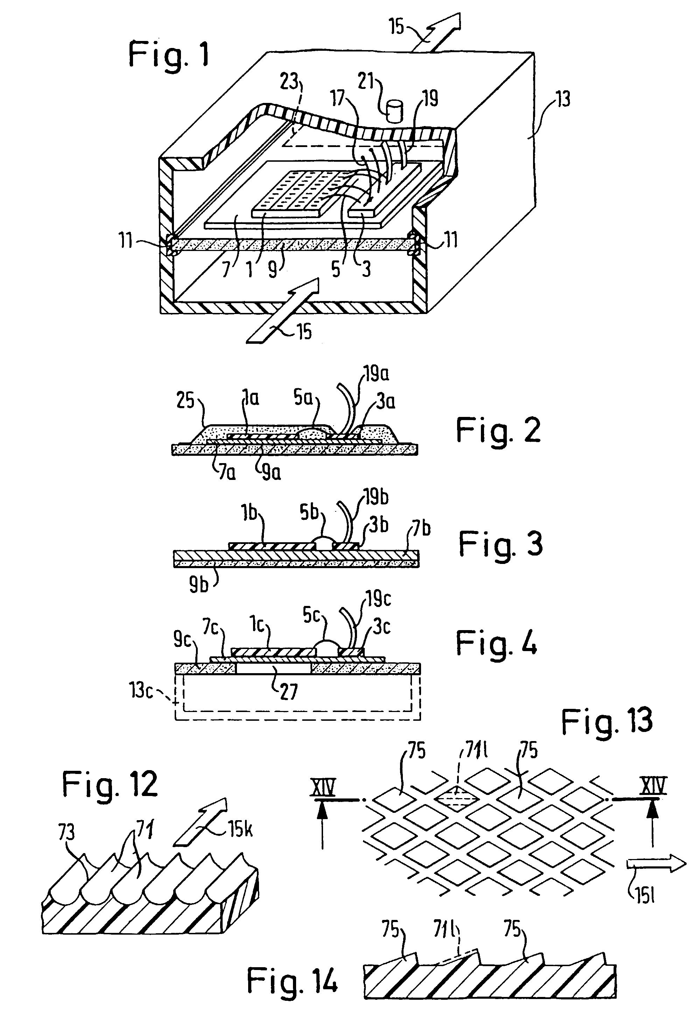

Figur 1 zeigt in einer Darstellung, in der die Dickenverhältnisse der einzelnen Komponenten nicht maßstabsgetreu sind, ein Leistungstransistormodul, hier ein IGBT-Modul, mit einem ersten Chip bzw. Halbleiterelement 1 mit einer mehrere Leistungstransistoren umfassenden Transistorschaltung und einem zweiten Chip bzw. Halbleiterelement 3, welches die Steuerelektronik und Schutzbeschaltung für die Leistungstransistoren enthält und über Verbindungsleitungen 5 mit dem ersten Halbleiterelement 1 verbunden ist. Die Halbleiterelemente 1, 3 sind stoffschlüssig mit einer beispielsweise eutektisch erzeugten, insbesondere aus Kupfer bestehenden Metallplattierung 7 fest verbunden. Die Metallplattierung 7 bildet den Kollektor der Leistungstransistoren des Halbleiterelements 1 und ist ebenso wie mit dem Halbleiterelement 1 mit einer keramischen Isolierplatte 9 stoffschlüssig, flächig und homogen verbunden. Die Isolierplatte 9 ist teilweise randseitig in Schienen 11 eines in Umfangsrichtung geschlossenen Kühlfluidkanals 13 gehalten, und zwar so, daß sowohl die der Isolierplatte 9 abgewandte Flachseite des Halbleiterelements 1 als auch die dem Halbleiterelement 1 abgewandte Flachseite der Isolierplatte 9 einer durch Pfeile 15 angedeuteten Kühlfluidströmung ausgesetzt ist. Als dünne Drähte ausgebildete Steuerleitungen 17 und als Kupferbänder ausgebildete Stromschienen 19 verbinden die Schaltungen der Halbleiterelemente 1, 3 mit auf der Außenseite des Kühlkanals 13 angeordneten Anschlüssen 21. Von den beiden Halbleiterelementen ist zumindest das Halbleiterelement 1, was den Wärmedurchgang anbetrifft, im wesentlichen unmittelbar dem Kühlfluidstrom 15 ausgesetzt, so daß es von beiden Seiten ganzflächig gekühlt wird. Trotz kompakter Abmessungen läßt sich auf diese Weise eine hohe Leistungsdichte erreichen. Da zwischen dem Halbleiterelement 1 und der Isolierplatte 9 lediglich die Metallplattierung 7 als einzige Zwischenschicht verbleibt, läßt sich mit hinreichender Sicherheit eine homogene, stoffschlüssige Verbindung zwischen Halbleiterelement 1 und Isolierplatte 9 erreichen, was der Temperaturfestigkeit und Betriebssicherheit des IGBT-Moduls zugute kommt. Die Schiene 11 ist vorzugsweise elastisch und isolierend (z.B. aus einem Elastomer) ausgeführt.

In dem Kühl kanal 13 können mehrere IGBT-Module in Strömungsrichtung 15 hintereinander auf einer gemeinsamen Isolierplatte angeordnet sein, wie dies bei 23 angedeutet ist. Es versteht sich, daß das Kühlfluid nicht auf beiden Seiten der Isolierplatte 9 durch den Kühlkanal 13 geleitet werden muß. Im Einzelfall kann es genügen, wenn lediglich auf der den Halbleiterelementen 1, 3 abgewandten Seite zwischen Isolierplatte 9 und Kühlkanal 13 ein Kühlfluid hindurchströmt. Alternativ kann auch lediglich der die Halbleiterelemente 1, 3 überdeckende Teil des Kühlkanals 13 vorhanden bzw. für die Kühlfluidströmung ausgenutzt sein. Es versteht sich, daß anstelle von IGBT-Modulen die Halbleiterelemente 1, 3 auch mit anderen Leistungstransistortypen realisiert sein können, beispielsweise Bipolar-Leistungstransistoren oder MOSFET-Leistungstransistoren.

Figur 2 zeigt eine Variante des IGBT-Moduls, die sich von dem Aufbau der Figur 1 lediglich dadurch unterscheidet, daß die über die Metallisierung 7a stoffschlüssig und ganzflächig auf der keramischen Isolierplatte 9a befestigten, wiederum plattenförmigen Halbleiterelemente 1a, 3a bis auf die Kontaktstellen der Steuerleitungen bzw. der Kontaktbänder 19a mit einer dünnen Schutzschicht 25 überzogen sind, die die aktive Zone der Halbleiterelemente 1a, 3a vor Kontaminierung mit dem Kühlfluid schützt. Bei der Schutzschicht 25 kann es sich beispielsweise um eine Beschichtung aus Silikonkautschuk handeln, die von einer Metallfolie nach außen hin abgedeckt ist. Zur weiteren Erläuterung wird hier, wie auch bei den nachfolgend beschriebenen Ausführungsbeispielen, auf die vorangegangenen Figuren und deren Beschreibung Bezug genommen, wobei zur Bezeichnung gleichwirkender Komponenten die Bezugszahlen der vorangegangenen Figuren benutzt werden, allerdings unter Hinzufügung eines unterscheidenden Buchstabens.

Figur 3 zeigt eine Variante eines IGBT-Moduls, dessen Halbleiterelemente 1b, 3b auf einer der Funktion nach der Metallisierung 7 entsprechenden Metallplatte 7b, beispielsweise einer Kupferplatte, geschlossenflächig, stoffschlüssig befestigt sind. Die Metallplatte 7b ist außerhalb der Bereiche der Halbleiterelemente 1b, 3b, zumindest jedoch auf der den Halbleiterelementen 1b, 3b abgewandten Flachseite mit einer Isolierschicht. beispielsweise einer dünnen Oxidschicht 9b, versehen. Die Metallplatte 7b übernimmt neben der Elektrodenfunktion die Befestigungsfunktion der Isolierplatte 9 aus Figur 1.

Figur 4 zeigt eine Variante, bei welcher die Halbleiterelemente 1c, 3c ganzflächig auf einer Metallisierung 7c angeordnet sind, die zugleich Elektrodenfunktion hat. Die Isolierplatte 9c ist hingegen mit einer durchgehenden, zumindest von dem die Leistungstransistoren enthaltenden Halbleiterelement 1c überlappten Aussparung 27 versehen, durch die hindurch das Kühlfluid unmittelbar in Wärmetauschkontakt mit der Metallisierung 7c und damit dem Halbleiterelement 1c treten kann, was die Verlustwärmeabfuhr erleichtert. Die Aussparung 27 überlappt das Halbleiterelement 1c im wesentlichen vollständig. Das Halbleiterelement 1c ist lediglich im Randbereich der Aussparung 27 auf der Isolierplatte 9c abgestützt. Wie in Figur 4 durch eine gestrichelte Linie 13c angedeutet, kann der Kühlkanal zusammen mit der Isolierplatte 9c auch die Form eines Profilrohres 13c, hier eines gegebenenfalls einteiligen Rechteckrohrs, haben, auf dem die Halbleiterelemente 1c, 3c nachträglich und von außen befestigt werden. Es versteht sich, daß derartige Kühlkanalkonstruktionen auch bei den Varianten der Figuren 1 bis 3 eingesetzt werden können.

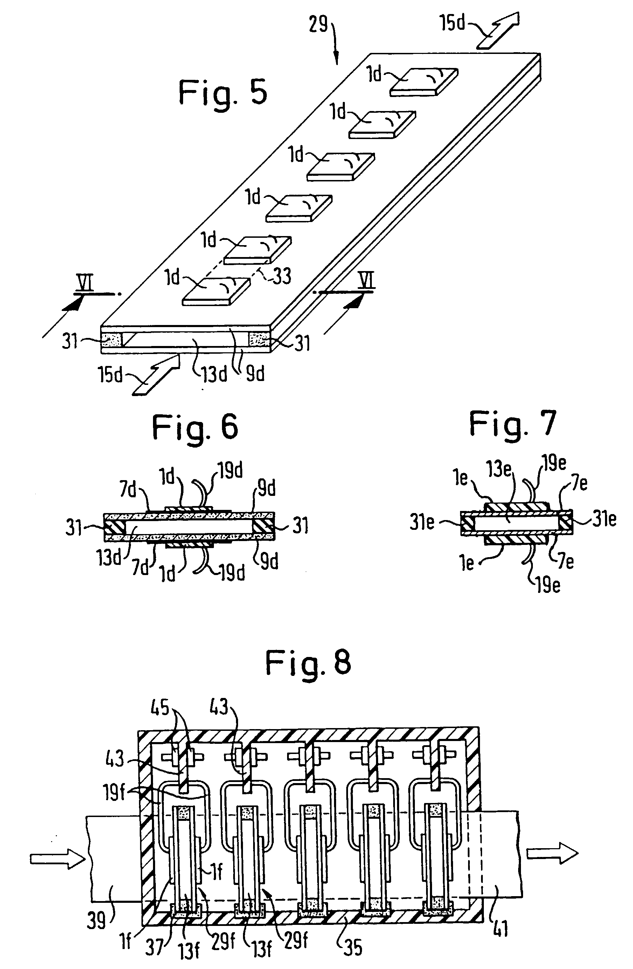

Figur 5 zeigt ein Ausführungsbeispiel, das es erlaubt, mehrere IGBT-Module, von denen jedes wie auch bei den zuvor erläuterten Beispielen ein elektrisches Ventil bildet, zu Ventilmodulen, insbesondere in Form von Halbbrücken oder Vollbrücken, teils in Parallel- oder Serienchaltung, gegebenenfalls auch mehrere dieser Brücken zusammenzufassen. Das allgemein mit 29 bezeichnete Modul umfaßt zwei zueinander parallel angeordnete, aus Keramikmaterial bestehende Isolierplatten 9d, die entlang ihrer Längsränder durch vorzugsweise elastische Dichtleisten 31 zu einem in Umfangsrichtung geschlossenen Kühlkanal 13d verbunden sind. Pfeile 15d deuten wiederum die Strömungsrichtung des Kühlfluids an. Jede der beiden Isolierplatte 9d trägt auf ihrer kühlkanalfernen Flachseite mehrere in Strömungsrichtung 15d hintereinander angeordnete Halbleiterelemente 1d, von denen jedes ein gesondertes IGBT-Ventil bildet. Die Anzahl der Halbleiterelemente 1d auf jeder der beiden Isolierplatten 9d ist gleich. Die Halbleiterelemente 1d sind, wie Figur 6 erkennen läßt, wiederum über Metallisierungen 7d auf die Isolierplatten 9d ganzflächig formschlüssig aufgebracht. Die Anschlüsse sind bei 19d zu erkennen. Die Schutz- und Steuerschaltungen für die IGBT-Module sind ebenso wie in den Figuren 6-8 nicht gesondert dargestellt. Es versteht sich, daß die Varianten der Figuren 2 bis 4 auch bei dem Modul 29 eingesetzt werden können.

In Figur 5 sind die Halbleiterelemente 1d jedes Ventils voneinander gesondert und im Abstand auf den Isolierplatten 9 angeordnet. Da Halbleiterelemente der in Rede stehenden Art üblicherweise in gleicher Gestaltung mehrfach nebeneinander auf Halbleitersubstratscheiben hergestellt werden, können gegebenenfalls auch mehrere der Halbleiterelemente 1d einstückig miteinander verbunden sein, wie dies in Figur 5 bei 33 angedeutet ist.

Figur 7 zeigt eine weitere Variante, die auf integral miteinander verbundenen Halbleiterelementen le aufbaut. Die Halbleiterelemente 1e von jeweils mehreren elektrischen Ventilen werden gemeinsam aus oer vorstehend erwähnten Substratscheibe ausgeschnitten und mit einer Metallisierung (Metallelektrode 7e) versehen. Die Metallelektroden 7e weisen auf der dem Kühlfluid zugewandten Seite eine elektrische Isolierschicht auf. Die Halbleiterelementplatten 1e sind zueinander parallel angeordnet und sind über abdichtende Abstandleisten 31e miteinander verbunden. Zusammen mit den Abstandleisten 31e begrenzen die Halbleiterelementplatten 1e einen in Umfangsrichtung geschlossenen Kühlkanal 13e. Die Anschlüsse der elektrischen Ventile sind bei 19e angedeutet.

Figur 8 zeigt schematisch, wie mehrere der Module 29 gemäß den Figuren 5 bis 7 zu einer Baueinheit vereinigt werden können. Die Module 29f sind in einem gemeinsamen Gehäuse 35 zueinander parallel in elastischen Schienen 37 gehalten. Ihr Kühlkanal 13f ist an einem Ende mit einem gemeinsamen Kühlfluid-Zuleitungskanal 39 und am anderen Ende mit einem gemeinsamen Kühlfluid-Ableitungskanal 41 verbunden. Den Modulen 29f sind in der Modulebene angeordnete Stützstege 43 zugeordnet, die mit Anschlußorganen 45 versehen sind. Die Anschlußorgane 45 dienen dem Anschluß der Steuerleitungen und Stromschienen und sind, wie durch Leitungen 19f angedeutet, mit den Halbleiterelementen 1f der Module 29f verbunden.

Bei dem Kühlfluid kann es sich um ein unter Atmosphärenüberdruck stehendes Gas, beispielsweise Stickstoff, eine Flüssigkeit, wie zum Beispiel Wasser, oder ein öl, speziell ein Öl auf Mineralbasis, auf Paraffinbasis oder um ein synthetisches öl handeln. Geeignet sind aber auch Zwei-Phasen-Fluide, wie zum Beispiel Kältemittel oder CO₂. Das Kühlfluid wird in einer Zwangsströmung im Kreislauf durch den Kühlkanal geleitet.

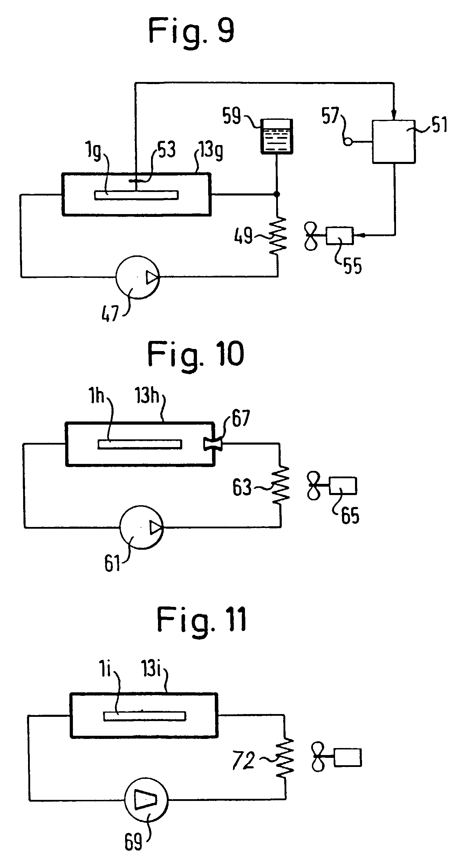

Figur 9 zeigt ein Ausführungsbeispiel für eine Kühlanordnung mit einer Flüssigkeit als Kühlfluid. Die Kühlflüssigkeit wird von einer Pumpe 47 über einen Kühler bzw. Wärmetauscher 49 dem Kühlkanal 13g im Kreislauf zugeführt. Die Kühlanordnung umfaßt einen Temperaturregelkreis 51, der mittels eines Temperaturfühlers 53 die Temperatur des bei 1g angedeuteten, in Wärmetauschkontakt mit der Kühlflüssigkeit stehenden Halbleiterelements mißt und beispielsweise mittels eines Lüfters 55, der die Kühlleistung des Kühlers 49 beeinflußt, die Halbleitertemperatur auf einen bei 57 einstellbaren Sollwert hält. Bei 59 ist der Vollständigkeit halber ein Ausgleichsgefäß für Kühlflüssigkeit angedeutet.

Figur 10 zeigt eine Variante, bei der zur Kühlung des Halbleiterelements 1h ein Zwei-Phasen-Kältemittel eingesetzt wird. Nach Art einer Wärmepumpe wird das von einem Kompressor 61 verdichtete Kältemittel in einem Kondensator 63, zum Beispiel mittels eines Lüfters 65 abgekühlt und verflüssigt. Der Kühlkanal 13h bildet einen Verdampfer, in welchem das flüssige Kältemittel über eine Düse 67 oder dergleichen eingeführt und durch Wärmeaufnahme verdampft wird. Die Verwendung des Kältemittels als Kühlfluid erlaubt einen kompakteren Aufbau der Kühlanordnung.

Figur 11 zeigt der Vollständigkeit halber einen geschlossenen Kühlmittelkreislauf für ein gasförmiges Kühlfluid, das von einem Kompressor 69 verdichtet wird, bevor es nachfolgend in einem Kühler bzw. Wärmetauscher 72 abgekühlt und dann dem Kühlkanal 13i für den Wärmetauschkontakt mit dem Halbleiterelement 1i zugeführt wird. Es versteht sich, daß auch die Varianten der Figuren 10 und 11 temperaturgeregelt ausgeführt sein können.

Der Wärmeübergang von den zu kühlenden Oberflächen der Halbleiterelemente bzw. der geschlossenflächig und stoffschlüssig mit den Halbleiterelementen verbundenen Metallplattierungen und Isolierplatten läßt sich insbesondere bei Flüssigkeiten als Kühlfluid durch Oberflächen-Mikrostrukturen verbessern, die die Grenzschichtdicke des Kühlfluids vermindern. Bei der Grenzschicht handelt es sich um den Bereich der Kühlfluidströmung, in welchem die Strömungsgeschwindigkeit durch die Reibung und Fluidhaftung an der Wandfläche vermindert wird. Es hat sich gezeigt, daß "Haifischhaut"-ähnliche Oberflächenstrukturen nicht nur die Fluidreibung an der Wandoberfläche mindern, sondern auch die Grenzschichtdicke herabsetzen. Mit abnehmender Grenzschichtdicke verkürzt sich der Abstand der die Wärme abgebenden Flächen zu den strömenden Bereichen des die Wärme aufnehmenden Kühlfluids.

Figur 12 zeigt ein Beispiel einer derartigen, die Grenzschichtdicke mindernden Oberflächen-Mikrostruktur. Die Mikrostruktur besteht aus einer Vielzahl zueinander paralleler, in Strömungsrichtung 15k des Kühlfluids verlaufender Rippen 71, deren Seitenflanken keilförmig zu einem schneidenartigen Rücken 73 sich verjüngen. Die Rippen 71 gehen in konkav gekrümmten Nuten ineinander über. Die Höhe der Rippen und ihr Abstand voneinander ist vorzugsweise kleiner als die Grenzschichtdicke.

Die in Figur 12 dargestellte Rippenform hat sich als zweckmäßig erwiesen; andere Rippenformen sind jedoch ebenfalls von Nutzen, beispielsweise Rippen mit gerundetem Rücken oder trapezförmige Rippen oder dergleichen.

Weitere grenzschichtmindernde Oberflächenstrukturen zeigen die Figuren 13 und 14. Diese Figuren zeigen in der Draufsicht rautenförmige Noppen bzw. Erhebungen 75, die in senkrecht zur zu kühlenden Oberfläche in Strömungsrichtung 15 l des Kühlfluids verlaufenden Ebenen keilförmig ansteigen. Die durch die Erhebungen 75 gebildeten Dachflächen können eben sein oder ebenfalls mit Mikrorippen ähnlich Figur 12 versehen sein, was bei 71 1 angedeutet ist. Anstelle der in Figur 13 dargestellten, in der Draufsicht rautenförmigen Kontur können die Erhebungen 75 auch andere, allgemein polygonförmige Konturen haben. Geeignet sind unter anderem auch Dreieckformen, die mit einer ihrer Ecken in Strömungsrichtung 15 l weisen. Auch beim Ausführungsbeispiel der Figuren 13 und 14 liegen die Abmessungen der Erhebungen 75 in der Größenordnung der Grenzschichtdicke.

Ein wesentlicher Vorteil erfindungsgemäßer Ventilstrukturen liegt darin, daß der Platzbedarf aufgrund der verbesserten Kühlung insgesamt verringert werden kann. Die elektrischen Ventile lassen sich damit besser als bisher in räumlicher Nachbarschaft zu den zu steuernden elektrischen Geräten unterbringen. Dies ist von besonderem Vorteil bei elektrischen Maschinen, beispielsweise Elektromotoren oder elektrischen Generatoren mit durch die elektrischen Ventile zu schaltenden Feldwicklungen, da die Feldwicklungen dann über sehr kurze Zuleitungen angeschlossen werden können. Durch Verkürzung der Zuleitungen kann die Schaltkreisinduktivität gesenkt und damit die Ansprechzeit der elektrischen Ventile verkürzt werden.

## Patentansprüche

1. Fluidgekühlte Leistungstransistoranordnung für elektrische Ventilanordnungen mit einem plattenförmigen Transistor-Halbleiterelement (1), das auf einer ersten seiner Flachseiten mit einem über das Halbleiterelement (1) vorstehenden, elektrisch isolierenden Isolierträger (9; 9a; 7b, 9b; 9c) verbunden ist, der mit mindestens einer seiner Flachseiten innerhalb einer Kühlfluid-Zwangsströmung (15) eines Fluidkanals (13) angeordnet ist, der in Wärmeübertragungskontakt mit zumindest einer der Flachseiten des Halbleiterelementes (1) steht und mit Mitteln zur Erzeugung der Kühlfluid-Zwangsströmung (15) verbunden ist,
dadurch gekennzeichnet, daß
- das Transistor-Halbleiterelement (1) auf einer seiner Flachseiten eine dieselbe abdeckende, in ihrer Flächenausdehnung die Fläche des Halbleiterlementes (1) überragende Metallelektrode (7) trägt, die geschlossenflächig, stoffschlüssig mit dem Halbleiterelement (1) verbunden ist und auf seiner anderen Flachseite mehrere im Abstand voneinander stoffschlüssig angebrachte Anschlüsse (5) aufweist,
- das Halbleiterlement (1) über seine mit dem Isolierträger (9; 9a; 7b, 9b, 9c) gemeinsame Kontaktfläche der Kühlwirkung der Kühlfluid-Zwangsströmung (15) ausgesetzt ist, und
- auf dem Isolierträger (9; 9a; 7b, 9b; 9c) eine Steuer- und Schutzbeschaltung (3) für das Halbleiterelement (1) angeordnet ist.

2. Leistungstransistoranordnung nach Anspruch 1,
dadurch gekennzeichnet,
daß das Halbleiterelement (1, 1a, 1d) mit seiner Metallelektrode (7, 7a, 7d) geschlossenflächig stoffschlüssig mit dem Isolierträger (9, 9a, 9d) verbunden ist.

3. Leistungstransistoranordnung nach einem der Ansprüche 1 bis 2,
dadurch gekennzeichnet,
daß der Isolierträger (9, 9a, 9c, 9d) insgesamt aus Isoliermaterial, vorzugsweise aus Keramik gebildet ist.

4. Leistungstransistoranordnung nach einem der Ansprüche 1 bis 2,
dadurch gekennzeichnet,
daß der Isolierträger als zumindest auf einer Flachseite mit einer Isolierschicht (9b) versehene Metallplatte (7b) ausgebildet ist.

5. Leistungstransistoranordnung nach Rnspruch 4,
dadurch gekennzeichnet,
daß die Metallplatte (7b) und die Metallelektrode integral ausgebildet sind.

6. Leistungstransistoranordnung nach einem der Ansprüche 1 bis 5,
dadurch gekennzeichnet,
daß die von dem Halbleiterelement (1, 1a, 1b) abgewandte Flachseite der Kühlfluid-Zwangsströmung ausgesetzt ist.

7. Leistungstransistoranordnung nach Anspruch 6,
dadurch gekennzeichnet,
daß das Halbleiterelement (1a) an seiner dem Isolierträger (9a) abgewandten Flachseite, die vorzugsweise mit einer Schutzbeschichtung (25) versehen ist, ebenfalls direkt der Kühlfluid-Zwangsströmung ausgesetzt ist.

8. Leistungstransistoranordnung nach einem der Ansprüche 1 bis 7,
dadurch gekennzeichnet,
daß die Metallelektrode (7, 7a, 7b, 7c, 7d) in Form einer Metallplatte ausgebildet ist, deren Größe die erste Flachseite des Halbleiterelements (1) vorzugsweise um mindestens 50 % überragt.

9. Leistungstransistoranordnung nach einem der Ansprüche 1 bis 8,
dadurch gekennzeichnet,
daß der Isolierträger (9; 9d) als Platte ausgebildet ist und eine Wand des Kühlfluidkanals (13; 13d) bildet.

10. Leistungstransistor nach Anspruch 9,
dadurch gekennzeichnet,
daß der Isolierträger (9; 9d) mehrere Halbleiterelemente (1; 1d) in Richtung der Kühlfluid-Zwangsströmung (15; 15d) hintereinander angeordnet gemeinsam trägt.

11. Leistungstransistor nach Anspruch 10 oder 11,
dadurch gekennzeichnet,
daß zumindest zwei sich gegenüberliegende Wände des Kühlfluidkanals (13d) durch plattenförmige, jeweils wenigstens ein Halbleiterelement (ld) tragende Isolierträger (9d) gebildet sind.

12. Leistungstransistoranordnung nach Rnspruch 11, dadurch
gekennzeichnet,
daß die beiden sich gegenüberliegenden Isolierträger (9d) eine gleiche Anzahl Halbleiterelemente (1d) tragen.

13. Leistungstransistoranordnung nach Rnspruch 11 oder 12,
dadurch gekennzeichnet,
daß die sich gegenüberliegenden Isolierträger (9d) durch Dichtleisten (31) zu einem in Umfangsrichtung geschlossenen Kühlfluidkanal (13d) verbunden sind.

14. Leistungstransistoranordnung nach einem der Ansprüche 1 bis 13,
dadurch gekennzeichnet,
daß der als Isoliermaterial-Trägerplatte ausgebildete Isolierträger (9c) eine von dem Halbleiterelement (1c) überdeckte, durchgehende Aussparung (27) aufweist, an deren Rändern das Halbleiterelement (1c) befestigt ist, und daß zumindest die erste Flachseite des Halbleiterelements (1c) mit der Metallelektrode (7c) durch die Aussparung (27) hindurch der Kühlfluidströmung ausgesetzt ist.

15. Leistungstransistoranordnung nach Anspruch 14,
dadurch gekennzeichnet,
daß der Isolierträger (9c) Teil eines Rechteckrohrs ist, das den Kühlfluidkanal (13c) bildet.

16. Leistungstransistoranordnung nach einem der Ansprüche 1 bis 15,
dadurch gekennzeichnet,
daß der Isolierträger (9, 9a, 9c, 9d) mehrere vorzugsweise einteilig miteinander verbundene, in Strömungsrichtung des Kühlfluids hintereinander angeordnete Halbleiterelemente (1, 1a, 1c, 1d) trägt, von denen jedes zumindest einen Leistungstransistor umfaßt.

17. Leistungstransistoranordnung nach einem der Ansprüche 1 bis 16,
dadurch gekennzeichnet,
daß zumindest zwei sich gegenüberliegende Wände des Kühlfluidkanals (13d) ausschließlich durch jeweils wenigstens ein, durch mehrere einteilig miteinander verbundene, in Strömungsrichtung des Kühlfluids hintereinander angeordnete Halbleiterelemente (1e), von denen jedes zumindest einen Leistungstransistor umfaßt, gebildet sind und die sich gegenüberliegenden Halbleiterelemente (1d) durch Dichtleisten (31) zu einem in Umfangsrichtung geschlossenen Kühlfluidkanal verbunden sind.

18. Leistungstransistoranordnung nach einem der Ansprüche 1 bis 17,
dadurch gekennzeichnet,
daß die Fluid-Kühlanordnung einen geschlossenen Kühlfluidkreislauf (13g, 47, 49; 13h, 61, 63; 13i, 69, 71) umfaßt, in welchem das Kühlfluid nacheinander durch den Kühlfluidkanal (13g; 13h; 13i) und einen Kühler (49; 63; 71) zirkuliert.

19. Leistungstransistoranordnung nach Anspruch 18,
dadurch gekennzeichnet,
daß der Kühlfluidkreislauf einen Verdampfer und einen Kondensator (63) umfaßt und daß der Kühlfluidkanal den Verdampfer (13h) bildet.

20. Leistungstransistoranordnung nach einem der Ansprüche 1 bis 19,
dadurch gekennzeichnet,
daß das Kühlfluid ein Gas oder eine Flüssigkeit wie öl oder ein Zwei-Phasen-Fluid ist.

21. Leistungstransistoranordnung nach einem der Ansprüche 1 bis 20,
dadurch gekennzeichnet,
daß der Isolierträger (9; 7b, 9b) in dem der Kühlfluidströmung ausgesetzten Bereich mit einer seine Wärmetauschfläche vergrößernden Struktur wie Rippen (71) oder Vorsprüngen (75), versehen ist.

22. Leistungstransistoranordnung nach einem der Ansprüche 1 bis 21,
dadurch gekennzeichnet,
daß zumindest ein Teil der der Kühlströmung ausgesetzten Oberfläche des Isolierträgers (9; 7b, 9b) oder des Halbleiterelements (1), mit einer die Dicke der Kühlfluid-Strömungsgrenzschicht mindernden Oberflächen-Mikrostruktur (71; 75) versehen ist.

23. Fluid-Kühlanordnung nach Rnspruch 22,
dadurch gekennzeichnet,
daß die Mikrostruktur als Rippenmuster mit in Strömungsrichtung (15k) der Kühlfluidströmung langgestreckten Mikrorippen (71) ausgebildet ist.

24. Fluid-Kühlanordnung nach Anspruch 23,
dadurch gekennzeichnet,
daß die Mikrorippen (71) zumindest angenähert zu einer Schneide (73) sich verjüngende Rücken haben.

25. Fluid-Kühlanordnung nach Anspruch 23 oder 24,
dadurch gekennzeichnet,
daß die Höhe der Rippen (71) und ihr Querabstand in der Größenordnung oder kleiner als die Grenzschichtdicke ist.

26. Fluid-Kühlanordnung nach einem der Ansprüche 22 bis 25,
dadurch gekennzeichnet,
daß die Mikrostruktur eine Vielzahl vorzugsweise in einem Raster angeordnete Mikroerhebungen (75) umfaßt.

27. Fluid-Kühlanordnung nach Rnspruch 26,
dadurch gekennzeichnet,
daß die Mikroerhebungen (75) in der Draufsicht Polygonform haben.

28. Fluid-Kühlanordnung nach Rnspruch 26 oder 27,
dadurch gekennzeichnet,
daß die Mikroerhebungen (75), gesehen in einer in Strömungsrichtung (15 l) verlaufenden Ebene, senkrecht zur Oberfläche keilförmig ansteigen.

## Claims

1. Fluid-cooled output transistor arrangement, for electrical valve arrangements, with a plate-shaped transistor-semiconductor component (1) which is connected, on one flat side, to an electrically insulating insulation-support (9; 7b, 9b; 9c) which projects out over a semiconductor component (1), and which, with at least one of its flat sides, is disposed inside a forced flow (15) of a coolant in a channel (13) which is in heat-transfer contact with at least one of flat sides of a semiconductor component (1) and which is connected with means for producing a forced flow (15) of a coolant,
characterized in that
- a transistor-semiconductor component (1) carries, on one of its flat sides, a metal electrode (4), which covers a said flat side, extending, with its surface-area beyond a surface concerned of a semiconductor component (1), a said metal electrode lying flush, with a closed surface, against a semiconductor component (1) and, on a second surface, has several material connections (5) at a distance of separation from each other,
- a semiconductor component (1) is subject to a cooling effect of a forced flow (15) of coolant over a surface which is common with a contact surface of an insulation support (9; 9a; 7b, 9b, 9c), and in that
- control and protection wiring (3) for a semiconductor component (1) is disposed on an insulator support (9; 9a; 7b, 9b; 9c).

2. Output transistor arrangement in accordance with claim 1,
characterized in that
semiconductor component (1, 1a, 1d) lies, with a metal electrode (7, 7a, 7d), in flush, closed connection with an insulation support (9, 9a, 9d).

3. Output transistor arrangement in accordance with either claim 1 or claim 2,
characterized in that
an insulation support (9, 9a, 9c, 9d), made wholly of insulating material, is preferably formed from ceramic material.

4. Output transistor arrangement in accordance with either of claims 1 or 2,
characterized in that
an insulation support is developed as a metal plate (7b) provided on one flat side with an insulation layer (9b).

5. Output transistor arrangement in accordance with claim 4,
characterized in that
a metal plate (7b) and a metal electrode are developed as a single piece.

6. Output transistor arrangement in accordance with any one of claims 1 to 5,
characterized in that
a flat side facing away from a semiconductor component (1, 1a, 1b) is exposed to a forced flow of a coolant.

7. Output transistor arrangement in accordance with claim 6,
characterized in that
a semiconductor component (la) is also directly exposed to a forced flow of coolant on a flat side which faces away from an insulation support (9a), which is preferably provided with a protection layer (25).

8. Output transistor arrangement in accordance with any one of claims 1 to 7,
characterized in that
a metal electrode (7, 7a, 7b, 7c, 7d) is developed as a metal plate which projects out over one flat side of a semiconductor component (1) by preferably 50% in terms of size.

9. Output transistor arrangement in accordance with any one of claims 1 to 6,
characterized in that
an insulation support (9; 9d) is developed as a plate and forms a wall of a coolant channel (13; 13d).

10. Output transistor arrangement in accordance with claim 9,
characterized in that
an insulation support (9; 9d) carries several semiconductor components (1; 1d) disposed one behind another in a direction of forced flow (15; 15d) of a coolant.

11. Output transistor arrangement in accordance with claim 10 or 11,
characterized in that
at least two opposite walls of a coolant channel (13d) are formed by plate-form insulation supports (9d) which each carry at least one semiconductor component (1d).

12. Output transistor arrangement in accordance with claim 11,
characterized in that
both of two opposite insulation supports (9d) carry an identical number of semiconductor components (1d).

13. Output transistor arrangement in accordance with claim 11 or 12,
characterized in that
opposite insulation supports (9d) are connected by sealing strips (31) to a coolant channel (13d) which is closed in a peripheral direction.

14. Output transistor arrangement in accordance with any one of claims 1 to 13,
characterized in that
an insulation support (9c) developed as an insulation-plate support-plate has an opening (27), covered by a semiconductor component (1c), onto rims of which a semiconductor component (1c) is attached, and in that at least one flat side of a semiconductor component (1c) with a metal electrode (7c) is exposed to flow of a coolant through a said opening (27).

15. Output transistor arrangement in accordance with claim 14,
characterized in that
an insulation support means (9c) is part of a right-angled pipe which forms a coolant channel (13c).

16. Output transistor arrangement in accordance with any one of claims 1 to 15,
characterized in that
an insulation support means (9, 9a, 9c, 9d) carries several semiconductor components (1, 1a, 1c, 1d) which are preferably connected to each other in a direction of flow concerned, each semiconductor component concerned including at least one output transistor.

17. Output transistor arrangement in accordance with any one of claims 1 to 16,
characterized in that
at least two opposite walls of a coolant channel (13d) are formed exclusively by, in each case, one at least or several single-piece semiconductor components (1e), each of which includes at least one output transistor, semiconductor components concerned being connected with each other, disposed one behind another in a direction of flow of a coolant, and in that opposite semiconductor components (1d) are connected to a coolant channel, which is closed in a longitudinal direction, by means of sealing strips (31).

18. Output transistor arrangement in accordance with any one of claims 1 to 17,
characterized in that
a fluid-cooling arrangement includes a closed circulation of coolant (13, 47, 49; 13h, 61, 63; 131, 69, 71) in which a coolant circulates successively through a coolant channel (13g; 13h; 13i) and a cooling radiator (49; 63; 71).

19. Output transistor arrangement in accordance with claim 18,
characterized in that
a circulation of coolant includes an evaporator and a condenser (63) and a coolant channel forms a said condenser (13h).

20. Output transistor arrangement in accordance with any one of claims 1 to 19,
characterized in that
a coolant concerned is a gas, a liquid such as oil or a biphase fluid.

21. Output transistor arrangement in accordance with any one of claims 1 to 20,
characterized in that
an insulation support means (9; 7b, 9b) is provided, in an area exposed to a flow of cooling fluid, with a structure which enlarges its heat-exchanging surface-area, such as a rib-structure (71) or a structure of projections (75).

22. Output transistor arrangement in accordance with any one of claims 1 to 21,
characterized in that
at least a part of a surface of an insulation support means (9; 7b, 9b) or a semiconductor component (1), which is exposed to a cooling flow, is provided with a surface microstructure (71; 75) which reduces breadth of a boundary layer of flow of cooling fluid.

23. Cooling-fluid arrangement in accordance with claim 22,
characterized in that
a microstructure concerned is developed as a rib design with microribs (71) extending, in a direction of flow (15k) of a cooling fluid.

24. Cooling-fluid arrangement in accordance with claim 23,
characterized in that
microribs (71) taper, at least almost, to a point (73).

25. Cooling-fluid arrangement in accordance with claim 23 or 24,
characterized in that
height of ribs (71) and their transverse separation is of a similar size to or smaller than a said boundary layer.

26. Cooling-fluid arrangement in accordance with any one of claims 22 to 25,
characterized in that
a microstructure includes a number of micro-rises (75) preferably arranged in a grid.

27. Cooling-fluid arrangement in accordance with claim 26,
characterized in that
micro-rises (75) have, in plan-view, polygonal form.

28. Cooling-fluid arrangement in accordance with claim 26 or 27,
characterized in that
microrises (75) rise vertically in relation to a surface concerned in a wedge form, as seen from a plane running in a direction of flow (151).

## Revendications

1. Dispositif à transistor de puissance refroidi par fluide pour des dispositifs électriques à soupape, comportant un élément semi-conducteur à transistor (1) en forme de plaque, qui est relié, par une première de ses faces planes, à un support isolant (9;9a;7b,9b;9c) isolant électriquement, faisant saillie au-delà de l'élément semi-conducteur (1) et agencé, par au moins l'une de ses faces planes, à l'intérieur d'un écoulement forcé de fluide de refroidissement (15) d'un canal de fluide (13), qui est en contact de transmission de chaleur avec au moins l'une des faces planes de l'élément semi-conducteur (1) et qui est relié à des moyens pour engendrer l'écoulement forcé de fluide de refroidissement (15),
caractérisé en ce que :
- l'élément semi-conducteur à transistor (1) porte, sur l'une de ses faces planes, une électrode métallique (7) recouvrant cette dernière, faisant saillie par son extension superficielle au-delà de la surface de l'élément semi-conducteur (1), reliée à l'élément semi-conducteur (1) par recouvrement superficiel et par liaison de matière, et présentant sur son autre face plane, plusieurs raccordements (5) agencés de façon écartée les uns des autres, par liaison de matière ;
- l'élément semi-conducteur (1) est soumis, par l'intermédiaire de sa face de contact commune avec le support isolant (9;9a;7b,9b;9c), à l'action de refroidissement de l'écoulement forcé de fluide de refroidissement (15), et
- un circuit de commande et de protection (3) pour l'élément semi-conducteur (1) est agencé sur le support isolant (9;9a;7b,9b;9c).

2. Dispositif à transistor de puissance selon la revendication 1,
caractérisé en ce que l'élément semi-conducteur (1,1a,1d) est relié, par son électrode métallique (7,7a,7d), au support isolant (9,9a,9d), par recouvrement superficiel et par liaison de matière..

3. Dispositif à transistor de puissance selon l'une des revendications 1 ou 2,
caractérisé en ce que le support isolant (9,9a,9c,9d) est réalisé globalement en un matériau isolant, de préférence en céramique.

4. Dispositif à transistor de puissance selon l'une des revendications 1 ou 2,
caractérisé en ce que le support isolant est réalisé sous forme d'une plaque métallique (7b) munie au moins sur une face plane d'une couche isolante (9b).

5. Dispositif à transistor de puissance selon la revendication 4,
caractérisé en ce que la plaque métallique (7b) et l'électrode métallique sont réalisées de façon intégrale.

6. Dispositif à transistor de puissance selon l'une des revendications 1 à 5,
caractérisé en ce que la face plane opposée à l'élément semi-conducteur (1,1a,1b) est soumise à l'écoulement forcé de fluide de refroidissement.

7. Dispositif à transistor de puissance selon la revendication 6,
caractérisé en ce que l'élément semi-conducteur (la) est soumis, sur sa face plane opposée au support isolant (9a) et munie de préférence d'une couche de protection (25), également directement à l'écoulement forcé de fluide de refroidissement.

8. Dispositif à transistor de puissance selon l'une des revendications 1 à 7,
caractérisé en ce que l'électrode métallique (7,7a,7b,7c,7d) est réalisée sous forme d'une plaque métallique, dont la taille fait saillie au-delà de la première face plane de l'élément semi-conducteur (1), de préférence d'au moins 50 %.

9. Dispositif à transistor de puissance selon l'une des revendications 1 à 8,
caractérisé en ce que le support isolant (9;9d) est réalisé sous forme de plaque et forme une paroi du canal de fluide de refroidissement (13;13d).

10. Transistor de puissance selon la revendication 9,
caractérisé en ce que le support isolant (9;9d) porte plusieurs éléments semi-conducteurs (1;1d) agencés l'un derrière l'autre en direction de l'écoulement forcé de fluide de refroidissement (15;15d).

11. Transistor de puissance selon l'une des revendications 10 ou 11,
caractérisé en ce qu'au moins deux parois en regard du canal de fluide de refroidissement (13d) sont formées par des supports isolants (9d) en forme de plaque, portant à chaque fois au moins un élément semi-conducteur (1d).

12. Dispositif à transistor de puissance selon la revendication 11,
caractérisé en ce que les deux supports isolants en regard (9d) portent un nombre identique d'éléments semi-conducteurs (1d).

13. Dispositif à transistor de puissance selon l'une des revendications 11 ou 12,
caractérisé en ce que les supports isolants en regard (9d) sont reliés, par des tiges d'étanchéité (31), en un canal de fluide de refroidissement (13d) fermé en direction périphérique.

14. Dispositif à transistor de puissance selon l'une des revendications 1 à 13,
caractérisé en ce que le support isolant (9c) réalisé sous forme de plaque de support en matériau isolant, présente un évidement (27) traversant et recouvert par l'élément semi-conducteur (1c), aux bords duquel est fixé l'élément semi-conducteur (1c), et en ce qu'au moins la première face plane de l'élément semi-conducteur (1c) avec l'électrode métallique (7c) est soumise, à travers l'évidement (27), à l'écoulement de fluide de refroidissement.

15. Dispositif à transistor de puissance selon la revendication 14,
caractérisé en ce que le support isolant (9c) fait partie d'un tube rectangulaire qui forme le canal de fluide de refroidissement (13c).

16. Dispositif à transistor de puissance selon l'une des revendications 1 à 15,
caractérisé en ce que le support isolant (9,9a,9c,9d) porte plusieurs éléments semi-conducteurs (1,1a,1c,1d) reliés ensemble de préférence en une pièce et agencés en direction d'écoulement du fluide de refroidissement les uns derrière les autres, desquels chacun comprend au moins un transistor de puissance.

17. Dispositif à transistor de puissance selon l'une des revendications 1 à 15,
caractérisé en ce qu'au moins deux parois en regard du canal de fluide de refroidissement (13d) sont formées exclusivement à chaque fois par au moins l'un des éléments semi-conducteurs (le) reliés ensemble en une seule pièce et agencés les uns derrière les autres en direction d'écoulement du fluide de refroidissement, desquels chacun comprend au moins un transistor de puissance, et les éléments semi-conducteurs (1d) en regard sont reliés, par des tiges d'étanchéité (31), en un canal de fluide de refroidissement fermé en direction périphérique.

18. Dispositif à transistor de puissance selon l'une des revendications 1 à 17,
caractérisé en ce que le dispositif à fluide de refroidissement comprend un circuit de fluide de refroidissement fermé (13g,47,49;13h,61,63;13i,69,71), dans lequel le fluide de refroidissement circule successivement à travers le canal de fluide de refroidissement (13g;13h;13i) et un élément de refroidissement (49;63;71).

19. Dispositif à transistor de puissance selon la revendication 18,
caractérisé en ce que le circuit de fluide de refroidissement comprend un vaporisateur et un condensateur (63), et en ce que le canal de fluide de refroidissement forme le vaporisateur (13h).

20. Dispositif à transistor de puissance selon l'une des revendications 1 à 19,
caractérisé en ce que le fluide de refroidissement est un gaz ou un liquide, comme de l'huile ou un fluide diphasique.

21. Dispositif à transistor de puissance selon l'une des revendications 1 à 20,
caractérisé en ce que le support isolant (9;7b,9b) est muni, dans la zone soumise à l'écoulement de fluide de refroidissement, d'une structure, comme des nervures (71) ou des saillies (75), augmentant sa surface d'échange de chaleur.

22. Dispositif à transistor de puissance selon l'une des revendications 1 à 21,
caractérisé en qu'au moins une partie de la surface soumise à l'écoulement de refroidissement, du support isolant (9;7b,9b) ou de l'élément semi-conducteur (1), est munie d'une microstructure superficielle (71;75) réduisant l'épaisseur de la couche de limitation d'écoulement de fluide de refroidissement.

23. Dispositif à fluide de refroidissement selon la revendication 22,
caractérisé en ce que la microstructure est réalisée sous forme de modèle à nervures, comportant des micronervures (71) étendues longitudinalement en direction d'écoulement (15k) de l'écoulement de fluide de refroidissement.

24. Dispositif à fluide de refroidissement selon la revendication 23,
caractérisé en ce que les micronervures (71) présentent des dos se rétrécissant au moins à peu près en une lame (73).

25. Dispositif à fluide de refroidissement selon l'une des revendications 23 ou 24,
caractérisé en ce que la hauteur des nervures (71) et leur écartement transversal sont situés dans l'ordre de grandeur de l'épaisseur de la couche de limitation, ou sont plus petits.

26. Dispositif à fluide de refroidissement selon l'une des revendications 22 à 25,
caractérisé en ce que la microstructure comprend une pluralité de microbosses (75) agencées de préférence sous forme de trame.

27. Dispositif à fluide de refroidissement selon la revendication 26,
caractérisé en ce que les microbosses (75) présentent, en vue en plan, une forme polygonale.

28. Dispositif à fluide de refroidissement selon l'une des revendications 26 ou 27,
caractérisé en ce que les microbosses (75) augmentent en forme de coin, perpendiculairement à la surface, dans un plan s'étendant dans la direction d'écoulement (151).
